# EUROPÄISCHE PATENTSCHRIFT

(11) **EP 0 900 971 B1**
(45) Veröffentlichungstag und Bekanntmachung des Hinweises auf die Patenterteilung: **02.05.2003**
(21) Anmeldenummer: 97115598.1
(22) Anmeldetag: 09.09.1997
(51) Int. Cl.: F21K 7/00

(54) **Beleuchtungsvorrichtung mit Leuchtdioden aufweisender Glasplatte und kombination einer Vitrine mit einer solchen Beleuchtungsvorrichtung**
Illumination device with LED's mounted on a glass plate and combination of a display case with such an illumination device
Dispositif d'éclairage avec diodes électroluminescentes montées sur une plaque en verre et combinaison présentoir avec tel dispositif d'éclairage

(43) Veröffentlichungstag der Anmeldung: 10.03.1999
(73) Patentinhaber: Glasbau Hahn GmbH & Co. KG, D-60314 Frankfurt (DE)
(72) Erfinder: Hahn, Thomas, 60314 Frankfurt am Main (DE)
(74) Vertreter: Reichel, Wolfgang, Dipl.-Ing.

(56) Entgegenhaltungen:
- WO-A-97/03460
- DE-C- 4 208 922
- FR-A- 2 624 712

## Beschreibung

Die Erfindung betrifft eine Beleuchtungsvorrichtung bestehend aus einer Vielzahl von auf der Fläche einer Trägerplatte befestigten Leuchtdioden, welche mit auf der Trägerplatte angebrachten Leiterbahnen elektrisch verbunden sind.

Die Erfindung betrifft ferner eine Kombination einer Vitrine mit einer Beleuchtungsvorrichtung.

Eine derartige Beleuchtungsvorrichtung ist aus der DE-PS 42 08 922 als nächstliegendem Stand der Technik bekannt. Dabei sind die Leuchtdioden auf einer lichtdurchlässigen Leiterplatte angebracht, und zwar auf der der abstrahlenden Seite gegenüberliegenden Seite. Die als Chips ausgebildeten Leuchtdioden, die auf der Innenseite der Leiterplatte angebracht sind, dienen bei einem Flächendisplay zur Ausleuchtung von Hintergrundflächen und sie sind jeweils über einen zugehörigen Draht gebunden. Der Innenseite gegenüber ist an dem die Leiterplatte umschließenden Gehäuse eine Reflexionsschicht vorhanden, so daß das von den Leuchtdioden nach hinten abgestrahlte Licht durch die lichtdurchlässige Leiterplatte hindurch reflektiert wird. Der Raum zwischen Leiterplatte und Gehäuse ist außerdem mit einer als Streukörper als wirkenden Vergußmasse ausgefüllt.

Über die Ausbildung der zu den Leuchtdiodenchips führenden Stromzuführungen wird in der Druckschrift nichts ausgesagt. Diese können jedoch als normale Leiterbahnen, d. h. lichtundurchlässig, ausgebildet sein, da die Leiterbahnen infolge des Streukörpers das von den Leuchtdioden erzeugte Licht und von der Reflexionsschicht zurückgeworfene Licht in seiner Intensität nicht beeinträchtigen.

Es ist andererseits eine Beleuchtungsvorrichtung der eingangs erwähnten Art aus dem Katalog vom Sommer 1997 der Firma Westfalia, Industriestraße 1, in 58083 Hagen bekannt, und zwar bei einem auf Seite 61 unten beschriebenen Infrarot-Schweinwerfer, welcher aus einer Vielzahl von matrixförmig angeordneten, auf einer Leiterplatte angebrachten Infrarot-Leuchtdioden gebildet ist. Die Stromzuführung für die Leuchtdioden erfolgt dabei über Leiterbahnen, welche sich auf der der Bestückungsseite der Leiterplatte abgewandten Seite der Leiterplatte befinden.

Leuchtdioden haben gegenüber Glühlampen den Vorteil, daß sie den größten Teil der zugeführten elektrischen Energie in Licht umsetzen und somit nur wenig Wärme erzeugen. Die Lichtleistung einer einzelnen Leuchtdiode ist zwar nicht sehr hoch, weshalb sich die Anordnung einer Vielzahl von Leuchtdioden empfiehlt, wie dies bereits erwähnt worden ist.

Es ist ferner aus der FR-OS 2 624 712 eine Vitrine mit drehbaren Präsentationsflächen bekannt. Die säulenförmige mehreckige Vitrine weist Seitenteile aus Glas auf und besitzt im Oberteil eine Beleuchtungsvorrichtung und im Innenraum scheibenförmige Präsentationsflächen, die kreisrund ausgebildet und im Abstand übereinander jeweils in ihrer Mitte an einer durch die Vitrine reichenden und senkrecht angebrachten Welle befestigt sind, wobei die Welle von einer im Oberteil der Vitrine untergebrachten Antriebsvorrichtung in eine drehende Bewegung versetzt werden kann. Die scheibenförmigen Präsentationsflächen bestehen dabei aus Glas.

Die Aufgabe der Erfindung besteht nun darin, eine Beleuchtungsvorrichtung der eingangs erwähnten Art dahingehend anzugeben, daß diese insbesondere zur Beleuchtung von Schaufenstern, Verkaufs- und/oder Ausstellungsvitrinen geeignet ist.

Ferner sollen Kombinationen aus einer Vitrine mit einer Beleuchtungsvorrichtung geschaffen werden.

Diese Aufgabe wird dadurch gelöst, daß die Trägerplatte als glasklare Glasplatte ausgebildet ist und daß die Leiterbahnen als elektrisch leitende, dünne und unsichtbare bzw. nahezu unsichtbare Schicht auf der Glasplatte aufgebracht sind.

Eine Kombination einer Vitrine mit einer solchen Beleuchtungsvorrichtung ist gemässen den Ansprüchen 9 bis 12 dadurch gekennzeichnet, dass die Glasplatte einen oder mehrere Teile einer Vitrine bildet, wobei nur die aufgebrachten Leuchtdioden und nicht auch noch die Leiterbahnen sichtbar sind. So kann beispielsweise eine derart ausgebildete Glasplatte als Zwischenboden zur Aufnahme einer Auslage eingesetzt werden, wobei die auf der Unterseite angebrachten Leuchtdioden nach unten Licht abstrahlen und die darunter liegende Auslage beleuchten, während die auf dem Zwischenboden liegende Auslage von den Leuchtdioden einer gleichartig ausgebildeten Glasplatte angestrahlt wird, welche den oberen Abschluß der Vitrine bildet. Es ist ebenso denkbar, die Beleuchtungsvorrichtung im Rahmen einer Schaufensterscheibe einzusetzen, wobei durch eine geeignete Anordnung der Leuchtdioden auf der Innenseite der Schaufensterscheibe eine Beleuchtung der Auslagen möglich ist. Ein weiteres Anwendungsgebiet ist der Einsatz zu Reklamezwecken, wobei durch die entsprechende Anordnung der Leuchtdioden auf der Innen- oder Außenseite eine Schaufensterscheibe die Darstellung von Schriftzeichen und Figuren möglich ist, ohne daß dabei eine Beeinträchtigung der optischen Eigenschaften derselben erfolgt, da die Leiterbahnen unsichtbar oder zumindest nahezu unsichtbar sind.

Es sei noch erwähnt, dass aus der WO 97/03460 ein Substrat zur Aufnahme von elektronischen Bauteilen bekannt. Das Substrat besteht aus einer Glasplatte, auf der elektronische Bauteile in Form von Dünnschichtelelementen wie z. B. Dioden, Kondensatoren und Widerstände aufgebracht sind, die von einer Schutzschicht überzogen sind. Die Leiterbahnen zum Anschluß der genannten Bauteile mit einem Chip sind durch eine verdrahtungsschicht miteinander verbunden, die lithographisch aufgebracht wird. Der Vorteil eines derartigen Aufbaus soll in einer hohen Packungsdichte liegen.

Vorteilhafte Weiterbildungen der Erfindung sind in den Unteransprüchen beschrieben.

Die Erfindung wird anhand eines Ausführungsbeispiels näher erläutert, welches in der Zeichnung dargestellt ist.

Es zeigt:
- Fig. 1,: die Draufsicht auf eine Glasplatte,
- Fig. 2,: die Seitenansicht einer Glasplatte und
- Fig. 3,: die perspektivische Ansicht einer Vitrine

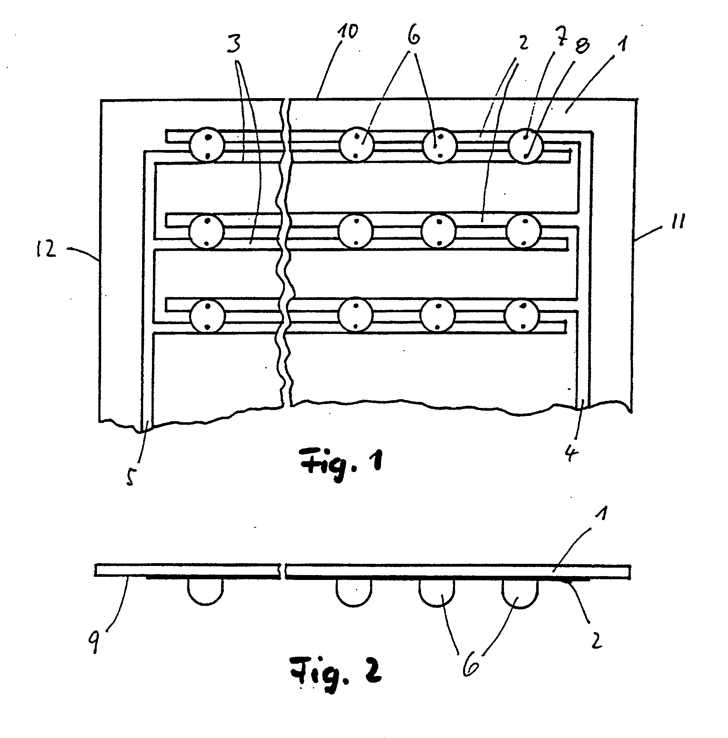

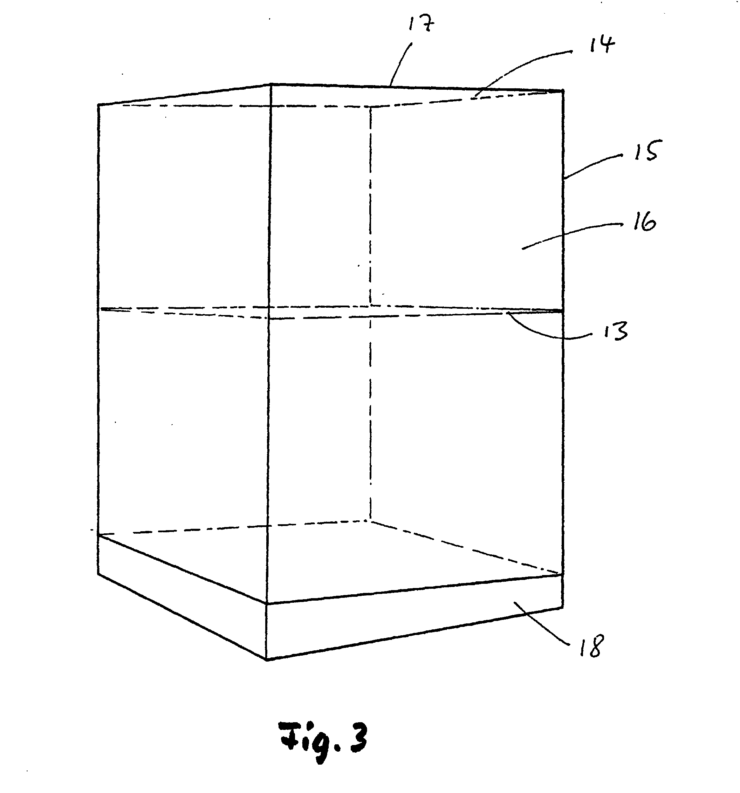

Wie in den Figuren 1 und 2 dargestellt, sind auf der einen Fläche 9 einer Glasplatte 1 erste Leiterbahnen 2 und zweite Leiterbahnen 3 abwechselnd parallel zu einer Außenkante 10 der Glasplatte 1 angebracht, wobei sämtliche erste Leiterbahnen 2 mit einem gemeinsamen Anschluß 4 und sämtliche zweite Leiterbahnen 3 mit einem gemeinsamen Anschluß 5 verbunden sind, und die Anschlüsse 4 und 5 jeweils ebenfalls als Leiterbahn ausgebildet sind, welche parallel zu den beiden Außenkanten 11 und 12 verlaufen, welche senkrecht zur Außenkante 10 stehen. Der Abstand der ersten Leiterbahn 2 zur zweiten Leiterbahn 3 ist derart gewählt, daß dieser dem Abstand zwischen dem ersten Anschluß 7 und dem zweiten Anschluß 8 einer Leuchtdiode 6 entspricht. Die Leiterbahnen 2,3,4 und 5 und die Leuchtdioden 6 können auch auf beiden Flächen der Glasplatte 1 angebracht sein. Unter einer Glasplatte 1 ist eine glasklare Glasplatte aus Mineralglas oder auch aus einem entsprechenden Kunststoff zu verstehen.

Die Leiterbahnen 2,3,4 und 5 werden durch Verdampfung von Metall auf die Glasplatte 1 aufgebracht, wobei die Abmessungen der einzelnen Leiterbahnen derart gewählt sind, daß diese zwar einerseits eine für die Stromzuführung ausreichende elektrische Leitfähigkeit aufweisen, andererseits in ihrer Dicke derart gehalten sind, daß diese unsichtbar, bzw. nahezu unsichtbar bleiben. Dort, wo eine Leuchtdiode 6 anzubringen ist, ist die elektrische Anschlußstelle für deren beide Anschlüsse 7 und 8 an den betreffenden Leiterbahnen 2 bzw. 3 verzinnt, so daß zwischen den Anschlüssen 7 und 8 einer Leuchtdiode 6 und den Leiterbahnen 2 bzw. 3 eine Lötverbindung herstellbar ist.

Als Leuchtdioden 6 kommen vorzugsweise solche Leuchtdioden zur Anwendung, welche ein weißes Licht erzeugen. Zum Erzielen eines anderen Farbtones können auch andersfarbige Leuchtdioden mit den weißes Licht erzeugenden Leuchtdioden kombiniert werden, dies gilt auch für die Erzielung besonderer Effekte.

Anhand der Abbildung gemäß Fig. 3 wird nun der Einsatz der erfindungsgemäßen Beleuchtungsvorrichtung bei einer Verkaufs- oder Ausstellungsvitrine näher erläutert, wobei die Anwendung der Beleuchtungsvorrichtung nicht nur auf derartige Vitrinen beschränkt ist. Ein weiteres Anwendungsgebiet der Erfindung ist beispielsweise der Einsatz zu Beleuchtungs- oder Werbezwecken, wobei auf einer Schaufensterscheibe durch die entsprechende Anordnung der Leuchtdioden auch Schriftzeichen und/oder auch Figuren durch die leuchtenden Dioden darstellbar sind. Durch die Anwendung der Erfindung werden dabei die optischen Eigenschaften einer glasklaren Schaufensterscheibe kaum beeinträchtigt, wenn diese oder ein Teil derselben als Glasplatte 1 ausgebildet ist.

In der in Fig. 3 gezeigten Vitrine ist die Glasplatte 1 als Zwischenboden 13 eingesetzt, wobei die Leuchtdioden 6 auf der unteren Fläche der Glasplatte 1 angebracht sind. Die Glasplatte 1 kann auch das Oberteil 14 der Vitrine 1 bilden oder an diesem auf der dem Innenraum der Vitrine zugewandten Seite angebracht sein, wobei ebenfalls das Licht der Leuchtdioden 6 nach unten in den Innenraum der Vitrine gerichtet ist. Ein weiterer Einsatz der Glasplatte 1 kann darin bestehen, daß diese als schmaler Streifen ausgebildet vor einer Ecke 15 der Vitrine angebracht ist, wobei die Leuchtdioden 6 wiederum auf der dem Innenraum der Vitrine zugewandten Seite der Glasplatte 1 angebracht sind. Es ist jedoch auch denkbar, aus optischen Gründen die Leuchtdioden 6 auch auf der, der Ecke 15 zugewandten Seite der Glasplatte 1 anzubringen. Auch eine oder mehrere vollständige Seitenwände 16 oder ein Teil derselben können als Glasplatte 1 ausgebildet sein. Die Stromzuführung zum Zwischenboden 13, zum Oberteil 14 oder zur Beleuchtung der Ecke 15 kann ebenfalls über Leiterbahnen erfolgen, die auf einer oder mehreren Seitenwänden 16 aufgebracht sind und diese Leiterbahnen den Leiterbahnen 2 und 3 der Glasplatte 1 in ihrem Aufbau entsprechen.

Die Stromversorgung der Leuchtdioden auf der im Rahmen einer Vitrine eingesetzten Glasplatte 1 kann durch eine Stromversorgungseinrichtung erfolgen, die beispielsweise im Unterteil 18 der Vitrine untergebracht ist. Diese weist einen Akkumulator auf, der durch eine auf der Oberseite 17 des Oberteils 14 angebrachte Solarzellenanordnung aufgeladen wird. Das Ein- und Ausschalten der Stromversorgungseinrichtung und die Helligkeitssteuerung der Leuchtdioden kann dabei über eine Fernsteuereinrichtung drahtlos erfolgen.

### Liste der Bezugszeichen

1 - Glasplatte
2 - erste Leiterbahn
3 - zweite Leiterbahn
4 - Anschluß der ersten Leiterbahn
5 - Anschluß der zweiten Leiterbahn
6 - Leuchtdiode
7 - erster Anschluß der Leuchtdiode
8 - zweiter Anschluß der Leuchtdiode
9 - Fläche
10 - Außenkante
11 - Außenkante
12 - Außenkante
13 - Zwischenboden
14 - Oberteil
15 - Ecke
16 - Seitenwand
17 - Oberseite
18 - Unterteil

## Patentansprüche

1. Beleuchtungsvorrichtung bestehend aus einer Vielzahl von auf der Fläche einer Trägerplatte befestigten Leuchtdioden, welche mit auf der Trägerplatte angebrachten Leiterbahnen elektrisch verbunden sind,
**dadurch gekennzeichnet,**
**daß** die Trägerplatte als glasklare Glasplatte (1) ausgebildet ist und
**daß** die Leiterbahnen (2,3) als elektrisch leitende, dünne und unsichtbare bzw. nahezu unsichtbare Schicht auf der Glasplatte (1) aufgebracht sind.

2. Beleuchtungsvorrichtung nach Anspruch 1,
**dadurch gekennzeichnet,**
**daß** die Anschlüsse (4,5) der Leiterbahnen (2,3) ebenfalls als elektrisch leitende, dünne und unsichtbare bzw. nahezu unsichtbare Schicht auf der Glasplatte (1) aufgebracht sind.

3. Beleuchtungsvorrichtung nach den Ansprüchen 1 oder 2,
**dadurch gekennzeichnet,**
**daß** die Leiterbahnen (2,3) und deren Anschlüsse (4,5) als Metallschicht auf die Glasplatte (1) aufgedampft sind.

4. Beleuchtungsvorrichtung nach einem der Ansprüche 1 bis 3,
**dadurch gekennzeichnet,**
**daß** die Leiterbahnen (2,3) und deren Anschlüsse (4,5) auf einer der beiden Flächen der Glasplatte (1) aufgebracht sind.

5. Beleuchtungsvorrichtung nach einem der Ansprüche 1 bis 4,
**dadurch gekennzeichnet,**
**daß** die Leuchtdioden (6) auf der, die Leiterbahnen (2,3) und deren Anschlüsse (4,5) tragenden Fläche (9) der Glasplatte (1) angebracht sind.

6. Beleuchtungsvorrichtung nach einem der Ansprüche 1 bis 5,
**dadurch gekennzeichnet,**
**daß** die Leuchtdioden (6) weißes Licht erzeugen.

7. Beleuchtungsvorrichtung nach einem der Ansprüche 1 bis 5,
**dadurch gekennzeichnet,**
**daß** einige der Leuchtdioden (6) weisses Licht und die verbliebenden Leuchtdioden (6) Licht einer anderen Farbe erzeugen.

8. Beleuchtungsvorrichtung nach einem der Ansprüche 1 bis 7,
**dadurch gekennzeichnet,**
**daß** beide Flächen der Glasplatte (1) mit Leiterbahnen (2,3), Anschlüssen (4,5) und/oder Leuchtdioden (6) versehen sind.

9. Kombination einer Vitrine mit einer Beleuchtungsvorrichtung nach Anspruch 1,
**dadurch gekennzeichnet,**
**daß** die Glasplatte (1) als Zwischenboden (13) in der Vitrine eingesetzt ist, wobei die Leuchtdioden (6) auf der Unterseite der Glasplatte (1) angebracht sind.

10. Kombination einer Vitrine mit einer Beleuchtungsvorrichtung nach Anspruch 1,
**dadurch gekennzeichnet,**
**daß** die Glasplatte (1) unterhalb des Oberteils (14) der Vitrine angebracht ist bzw. das Oberteil (14) selbst bildet, wobei sich die Leuchtdioden (6) auf der dem Innenraum der Vitrine zugewandten Seite Glasplatte (1) befinden.

11. Kombination einer Vitrine mit einer Beleuchtungsvorrichtung nach Anspruch 1,
**dadurch gekennzeichnet,**
**daß** die Glasplatte (1) in Form eines schmalen Streifens in einer oder mehreren Ecken (15) innerhalb der Vitrine angebracht ist, wobei die Leuchtdioden (6) sich auf der dem Innenraum der Vitrine zugewandten Seite der Glasplatte (1) befinden.

12. Kombination einer Vitrine mit einer Beleuchtungsvorrichtung nach Anspruch 1,
**dadurch gekennzeichnet,**
**daß** eine ganze Seitenwand (16) oder auch nur ein Teil derselben der Vitrine aus der Glasplatte (1) gebildet wird, wobei die Leuchtdioden (6) sich auf der dem Innenraum der Vitrine zugewandten Seite befinden.

13. Kombination einer Vitrine mit einer Beleuchtungsvorrichtung nach Anspruch 1,
**dadurch gekennzeichnet,**
**daß** die Leuchtdioden (6) von einer Stromversorgungseinrichtung mit elektrischer Energie versorgt werden, die in der Vitrine eingebaut ist.

14. Kombination einer Vitrine mit einer Beleuchtungsvorrichtung nach Anspruch 13,
**dadurch gekennzeichnet,**
**daß** die Stromversorgungseinrichtung einen Akkumulator aufweist, welcher von auf der Oberseite (17) der Vitrine angebrachten Solarzellen aufladbar ist.

15. Kombination einer Vitrine mit einer Beleuchtungsvorrichtung nach Anspruch 13 oder 14,
**dadurch gekennzeichnet,**
**daß** die Stromversorgungseinrichtung durch eine drahtlose Fernsteuereinrichtung ein- und ausschaltbar und/oder daß die Helligkeit der Leuchtdioden (6) über die Fernsteuereinrichtung einstellbar ist.

16. Kombination einer Vitrine mit einer Beleuchtungsvorrichtung nach einem der Ansprüche 9 bis 15,
**dadurch gekennzeichnet,**
**daß** die Zuleitungen zu den Anschlüssen (4,5) der Leiterbahnen (2,3) in Form von Leiterbahnen ausgebildet sind, welche den Leiterbahnen (2,3) der Glasplatte (1) im Aufbau entsprechen und welche auf einer oder mehreren Seitenwänden (16) der Vitrine aufgebracht sind.

## Claims

1. Illumination device comprising a large number of light emitting diodes which are secured to the surface of a carrier plate and which are electrically connected to conductor tracks attached to the carrier plate,
**characterised in that**
the carrier plate is configured as a crystal-clear glass plate (1) and **in that** the conductor tracks (2,3) are applied to the glass plate (1) as an electrically conducting, thin and invisible or practically invisible layer.

2. Illumination device according to claim 1, **characterised in that** the connections (4,5) of the conductor tracks (2,3) are also applied to the glass plate (1) as an electrically conducting, thin and invisible or practically invisible layer.

3. Illumination device according to claims 1 or 2, **characterised in that** the conductor tracks (2,3) and their connections (4,5) are vapour-deposited as a metal layer onto the glass plate (1).

4. Illumination device according to one of claims 1 to 3, **characterised in that** the conductor tracks (2,3) and their connections (4,5) are applied to one ofthe two surfaces of the glass plate (1).

5. Illumination device according to one of claims 1 to 4, **characterised in that** the light emitting diodes (6) are attached to the surface (9) of the glass plate (1) which bears the conductor tracks (2,3) and their connections (4,5).

6. Illumination device according to one of claims 1 to 5, **characterised in that** the light emitting diodes (6) produce white light.

7. Illumination device according to one of claims 1 to 5, **characterised in that** some of the light emitting diodes (6) produce white light and the remaining light emitting diodes (6) produce light of some other colour.

8. Illumination device according to one of claims 1 to 7, **characterised in that** both surfaces of the glass plate (1) are provided with conductor tracks (2,3), connections (4,5) and/or light emitting diodes (6).

9. Combination of a showcase with an illumination device according to claim 1, **characterised in that** the glass plate (1) is inserted as an intermediate base (13), the light emitting diodes (6) being located on the underside of the glass plate (1).

10. Combination of a showcase with an illumination device according to claim 1, **characterised in that** the glass plate (1) is attached below the upper portion (14) of the showcase or respectively forms the upper portion (14) itself, the light emitting diodes (6) being located on the side of the glass plate (1) facing the interior of the showcase.

11. Combination of a showcase with an illumination device according to claim 1, **characterised in that** the glass plate (1) is attached in the form of a narrow strip in one or more corners (15) inside the showcase, the light emitting diodes (6) being located on the side of the glass plate (1) facing the interior of the showcase.

12. Combination of a showcase with an illumination device according to claim 1,
**characterised in that**
an entire side wall (16), or also only a portion of same, of the showcase is formed from the glass plate (1), the light emitting diodes (6) being located on the side facing the interior of the showcase.

13. Combination of a showcase with an illumination device according to claim 1, **characterised in that** the light emitting diodes (6) are supplied with electrical energy by a power supply device which is installed in the showcase.

14. Combination of a showcase with an illumination device according to claim 13,
**characterised in that** the power supply device has an accumulator which can be charged by solar cells attached to the upper face (17) of the showcase.

15. Combination of a showcase with an illumination device according to one of claims 13 or 14, **characterised in that** the power supply device can be switched on and off by a wireless remote control device and/or **in that** the bzightness of the light emitting diodes (6) can be adjusted via the remote control device.

16. Combination of a showcase with an illumination device according to one of claims 9 to 15, **characterised in that** the supply lines to the connections (4,5) of the conductor tracks (2,3) are configured in the form of conductor tracks which correspond in structure to the conductor tracks (2,3) of the glass plate (1) and which are applied to one or more side walls (16) of the showcase.

## Revendications

1. Dispositif d'éclairage formé d'une pluralité de diodes électroluminescentes fixées sur la surface d'une plaque support, les diodes étant reliées électriquement par des pistes conductrices placées sur la plaque support, **caractérisé en ce que** la plaque support est réalisée sous la forme de plaque en verre (1) ayant la transparence du verre, et **en ce que** les pistes conductrices (2, 3) sont appliquées sous la forme d'une couche conductrice d'électricité mince et invisible ou à peu prés invisible, sur la plaque de verre (1).

2. Dispositif d'éclairage selon la revendication 1, **caractérisé en ce que** les raccordements (4, 5) des pistes conductrices (2, 3) sont également appliqués sous forme de couche conductrice d'électricité mince et invisible, ou à peu près invisible, sur la plaque de verre (1).

3. Dispositif d'éclairage selon l'une des revendications 1 ou 2, **caractérisé en ce que** les pistes conductrices (2, 3) et leurs raccordements (4, 5) sont appliqués par dépôt d'une couche métallique en phase de vapeur sur la plaque de verre (1).

4. Dispositif d'éclairage selon l'une des revendications 1 à 3, **caractérisé en ce que** les pistes conductrices (2, 3) et leurs raccordements (4, 5) sont appliqués sur l'une des deux faces de la plaque de verre (1).

5. Dispositif d'éclairage selon l'une des revendications 1 à 4, **caractérisé en ce que** les diodes électroluminescentes (6) sont montées sur la face (9) de la plaque de verre (1) portant les pistes conductrices (2, 3) et leurs raccordements (4, 5).

6. Dispositif d'éclairage selon l'une des revendications 1 à 5, **caractérisé en ce que** les diodes électroluminescentes (6) produisent de la lumière blanche.

7. Dispositif d'éclairage selon l'une des revendications 1 à 5, **caractérisé en ce que** quelques unes des diodes électroluminescentes (6) produisent de la lumière blanche et les diodes électroluminescentes (6) restantes produisent de la lumière d'une autre couleur.

8. Dispositif d'éclairage selon l'une des revendications 1 à 7, **caractérisé en ce que** les deux faces de la plaque de verre (1) sont munies de pistes conductrices (2, 3), de raccordements (4, 5) et/ou de diodes électro-luminescentes (6).

9. Combinaison d'un présentoir avec un dispositif d'éclairage selon la revendication 1, **caractérisée en ce que** la plaque de verre (1) est insérée à titre de fond intermédiaire (13), les diodes électroluminescentes (6) étant montées sur la face inférieure de la plaque de verre (1).

10. Combinaison d'un présentoir avec un dispositif d'éclairage selon la revendication 1, **caractérisée en ce que** la plaque de verre (1) est montée au-dessous de la partie supérieure (14) du présentoir ou bien forme la partie supérieure (14) elle-même, les diodes électroluminescentes (6) se trouvant sur la face de la plaque de verre (1) tournée vers le volume intérieur du présentoir.

11. Combinaison d'un présentoir avec un dispositif d'éclairage selon la revendication 1, **caractérisée en ce que** la plaque de verre (1) est montée, à la forme d'une bande étroite, dans un ou plusieurs angles (15) à l'intérieur du présentoir, les diodes électroluminescentes (6) se trouvant sur la face de la plaque de verre (1) tournée vers le volume intérieur du présentoir.

12. Combinaison d'un présentoir avec un dispositif d'éclairage selon la revendication 1, **caractérisée en ce qu'**une paroi latérale (16) complète, ou également uniquement une partie de celle-ci, du présentoir est formé de la plaque de verre (1), les diodes électroluminescentes (6) se trouvant sur la face tournée vers le volume intérieur du présentoir.

13. Combinaison d'un présentoir avec un dispositif d'éclairage selon la revendication 1, **caractérisée en ce que** les diodes électroluminescentes (6) sont alimentées en énergie électrique par un dispositif d'alimentation électrique intégré dans le présentoir.

14. Combinaison d'un présentoir avec un dispositif d'éclairage selon la revendication 13, **caractérisée en ce que** le dispositif d'alimentation électrique présente un accumulateur pouvant être chargé par des piles solaires montées sur la face supérieure (17) du présentoir.

15. Combinaison d'un présentoir avec un dispositif d'éclairage selon l'une des revendications 13 ou 4, **caractérisée en ce que** le dispositif d'alimentation électrique est susceptible d'être mis en service et hors service au moyen d'un dispositif de télécommande sans fil et/ou **en ce que** la luminosité des diodes électroluminescentes (6) est réglable par l'intermédiaire du dispositif de télécommande.

16. Combinaison d'un présentoir avec un dispositif d'éclairage selon l'une des revendications 9 à 15, **caractérisée en ce que** les lignes d'alimentation aux raccordements (4, 5) des pistes conductrices (2,3) sont réalisées sous la forme de pistes conductrices, dont la configuration correspond aux pistes conductrices (2, 3) de la plaque de verre (1) et qui sont montées sur une ou plusieurs parois latérales (16) du présentoir.
